Europäisches Patentamt

European Patent Office

Office européen des brevets

(11) Publication number: **0 178 916 B1**

## EUROPEAN PATENT SPECIFICATION

(45) Date of publication of patent specification: **22.07.92**  (51) Int. Cl.5: **G01B 7/06**, C23C 14/54

(21) Application number: **85307434.2**

(22) Date of filing: **16.10.85**

(54) A method of and apparatus for monitoring coating thickness.

(30) Priority: **19.10.84 GB 8426485**

(43) Date of publication of application:
**23.04.86 Bulletin 86/17**

(45) Publication of the grant of the patent:
**22.07.92 Bulletin 92/30**

(84) Designated Contracting States:
**CH DE FR GB IT LI NL SE**

(56) References cited:
**CH-A- 456 197**
**DE-A- 3 335 766**
**DE-A- 3 401 466**
**DE-U- 1 964 917**

(73) Proprietor: **GENERAL VACUUM EQUIPMENT LIMITED**
**Wolseley Road**
**GB-Kempston, Bedfordshire MK42 7XT(GB)**

(72) Inventor: **Casey, Frank**
**15 Wordsworth Way**
**Rochdale Lancashire(GB)**
Inventor: **Smith, Rodney Eric**
**31 Newhaven Close**
**Bury, BL8 1XX(GB)**

(74) Representative: **Downey, William Gerrard et al**
**WILSON GUNN & ELLIS 41-51 Royal Exchange Cross Street**
**Manchester M2 7BD(GB)**

EP 0 178 916 B1

## Description

The present invention relates to a method of and apparatus for monitoring the thickness of a metallic coating.

The method and apparatus are intended particularly, but not exclusively, for use in vacuum metallizers. In such metallizers, a substrate web is drawn from a supply reel over metallizing baths and fed to a take up reel. Coating thickness is monitored across the width of the web in order to ensure, as far as possible, a consistently coated product. One method of monitoring involves transmitting a beam of light through the coated web. The light transmitted is sensed by an optical sensor on the side of the web remote from the light transmitter, the level of light transmitted being a measure of the coating thickness. This method works reasonably well when coating thicknesses are small, but as coating thicknesses increase progressively less light is transmitted and difficulties of light measurement increase. Another method of monitoring involves measuring the resistance of the web to give an indication of coating thickness. This method gives an average coating thickness across the width of the web, but does not enable variations across the width to be monitored.

CH-A-456 197 discloses an arrangement in which a plurality of coils are disposed relative to magnetic material in order to detect faults in such material. This is insensitive and would not detect thin metal coatings.

According to one aspect of the present invention, there is provided a method of monitoring the thickness of a metallic coating on a substrate W including the steps of placing an inductance L adjacent the substrate, producing relative movement between the inductance L and the substrate W characterised in that the inductance L together with a capacitor C provides a tuned circuit which forms a Q meter and the change in Q of the meter is measured during relative movement.

According to another aspect of the present invention, there is provided apparatus for monitoring the thickness of a metallic coating on a substrate W comprising means for supporting the substrate 9, an inductance L, means for supporting the inductance adjacent the substrate and means for producing relative movement between the substrate 9 and the inductance L, characterised in that the inductance L forms part of a Q meter.

The invention also includes metallic substrate coated by using the above defined method and apparatus.

In order that the invention may be more clearly understood, one embodiment thereof will now be described, by way of example, with reference to the accompanying drawing, in which:-

Figure 1 is a diagrammatic sectional view of one form of vacuum metallizer to which the present invention may be applied,

Figure 2 is a diagrammatic view of a monitoring apparatus according to the present invention,

Figure 3 is an elevational view of the apparatus of Figure 2, and

Figure 4 is a circuit diagram of part of the apparatus of Figures 2 and 3.

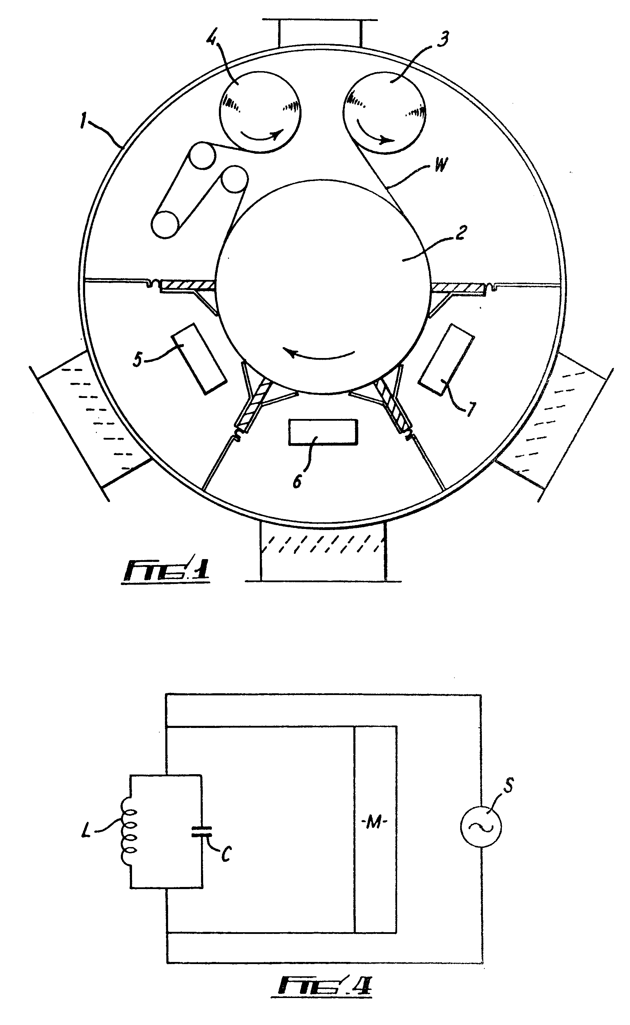

Referring to Figure 1 very briefly the metallizer comprises a housing 1 defining a vacuum chamber and housing a working roll 2. A web W is fed from a supply reel 3 to a take-up reel 4 over a working roll 2. Three metallizing sources 5 to 7 disposed in respective sub-chambers are provided adjacent the roll 2. The sub-chambers are provided with respective vacuum pumps.

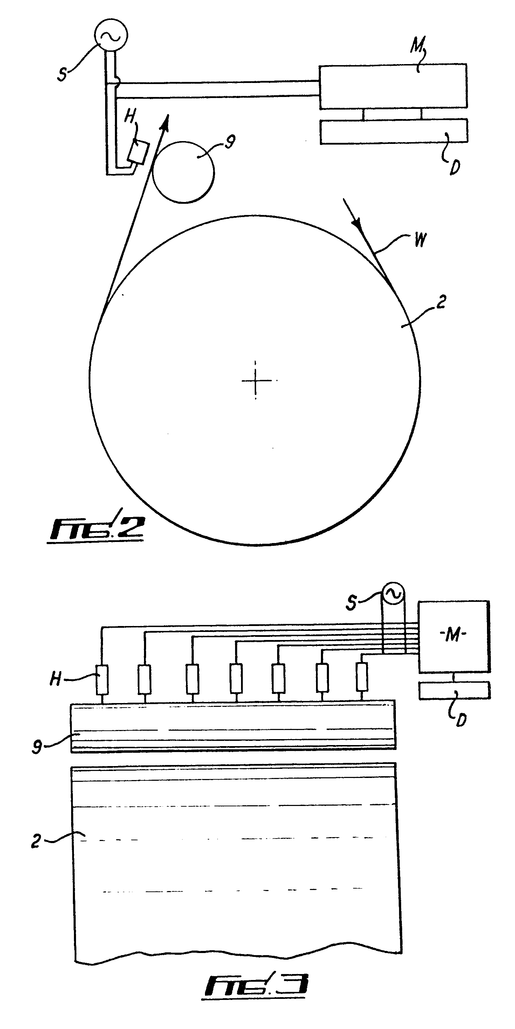

Referring to Figures 2 and 3, the web W passes round a non-metallic roller 9. This may be made of solid PTFE or other suitable material. The monitor has seven monitor heads H arranged at spaced intervals across the width of the web adjacent the web where it passes over roller 9. Fewer or more heads may be employed as desired. Referring to Figure 4 each head comprises a coil L which, together with a capacitor C, forms a tuned circuit. The circuit is connected to a source S of high frequency current and also to a detection circuit D. A plurality of sources and detection circuits may be provided for respective tuned circuits, but advantageously only one such source and circuit is provided, the outputs from the heads being multiplexed by means of a multiplexer M.

In operation, the currents induced in the metallic coating of the web W by the currents in the coils L have the effect of changing the Q's of the tuned circuit. This change is an indication of coating thickness, adjacent the coil in question. The detector D may be calibrated directly in units of thickness.

The Q of the tuned circuit voltage multiplication ratios may vary from 10 to 300.

By operating at frequencies from 2-5 megahertz and by using coils with small numbers of turns (thus increasing the inductive coupling to the film) very high sensitivity can be achieved.

It is possible to measure resistivities from 5-100 ohms/square with a better than 2% repeatability. Resistivities of 0.5 to 100,000 ohms/square can be measured by using the same technique at different frequencies.

Maximum sensitivity is achieved with the largest coils possible. For a given resistivity it may be possible to preset the range either by changing coils or by changing the frequency. A single frequency instrument with fixed probe coils could cover a 10:1 range of resistivity measurements.

Scanning electronics may be employed to automatically select the frequency corresponding to the resistivity being measured.

The coils would be fixed and may take the form of a PCB layout to increase uniformity and reliability.

Since it is impractical to have coils on either side of the web a single set of coils may be rigidly mounted about 1/4" above the film at a point where it passes over a non metallic (solid PTFE) roller. If necessary the coils could be curved.

The coils should be about 1" high and could be mounted at 123mm intervals - one over each evaporating boat - on a "U" section beam. (1 inch = 25.4 mm).

By precalibrating each set of read heads H it should be possible to avoid onerous linear interpolation and the voltage output from the Q meter would be fed to a simple 'look up table' from which it would generate a direct RS232C or similar readout to a printer and/or a central controlling computer.

The above described apparatus and method permit variations in coating thickness across the width of the web to be monitored. It also permits monitoring over a wide range of coating thicknesses.

It will be appreciated that the above embodiment has been described by way of example only and that many variations are possible without departing from the scope of the invention as claimed.

## Claims

1. A method of monitoring the thickness of a metallic coating on a substrate (W) including the steps of placing an inductance (L) adjacent the substrate, producing relative movement between the inductance (L) and the substrate (W) characterised in that the inductance (L) together with a capacitor (C) provides a tuned circuit which forms a Q meter and the change in Q of the meter is measured during relative movement.

2. A method of monitoring the thickness of a metallic coating as claimed in claim 1, in which the Q meter comprises a number of heads (H) which are disposed at spaced intervals across the substrate (W).

3. A method of monitoring the thickness of a metallic coating as claimed in claim 2, in which the outputs from the heads (H) are multiplexed.

4. A method of monitoring the thickness of a metallic coating as claimed in claim 1, in which the meter is supplied with current at a frequency from 2-5 megahertz.

5. Apparatus for monitoring the thickness of a metallic coating on a substrate (W) comprising means for supporting the substrate (9), an inductance (L), means for supporting the inductance adjacent the substrate and means for producing relative movement between the substrate (9) and the inductance (L), characterised in that the inductance (L) forms part of a Q meter.

6. Apparatus for monitoring as claimed in claim 5, in which the Q meter comprises a number of heads (H) which are disposed at spaced intervals across the substrate (W).

7. Apparatus for monitoring as claimed in claim 6, in which the heads (H) are connected to a multiplexer (M).

8. Apparatus for monitoring as claimed in claim 5, in which a source (S) of current in the frequency range 2-5 megahertz is connected to the meter.

## Revendications

1. Procédé de surveillance de l'épaisseur d'un revêtement métallique sur un substrat (W), dans lequel on place une inductance (L) adjacente au substrat, on produit un déplacement relatif entre l'inductance (L) et le substrat (W), caractérisé par le fait que l'inductance (L) constitue, conjointement avec un condensateur (C), un circuit accordé qui forme un Q-mètre et la variation de Q du Q-mètre est mesurée pendant le déplacement relatif.

2. Procédé de surveillance de l'épaisseur d'un revêtement métallique selon la revendication 1, dans lequel le Q-mètre comprend un certain nombre de têtes (H) disposées à intervalles espacés sur le substrat (W).

3. Procédé de surveillance de l'épaisseur d'un revêtement métallique selon la revendication 1, dans lequel les têtes (H) sont multiplexées.

4. Procédé de surveillance de l'épaisseur d'un revêtement métallique selon la revendication 1, dans lequel le Q-mètre est alimenté avec un courant à une fréquence allant de 2 à 5 megaherz.

5. Dispositif de surveillance de l'épaisseur d'un revêtement métallique sur un substrat (W), comprenant un moyen pour supporter le substrat (9), une inductance (L), un moyen pour supporter l'inductance adjacente au substrat, et un moyen pour produire un déplacement relatif entre l'inductance (L) et le substrat (9), caractérisé par le fait que l'inductance (L) fait partie d'un Q-mètre.

6. Dispositif de surveillance selon la revendication 5, dans lequel le Q-mètre comprend un certain nombre de têtes (H) disposées à intervalles espacés sur le substrat (W).

7. Dispositif de surveillance selon la revendication 6, dans lequel les têtes (H) sont reliées à un multiplexeur (M).

8. Dispositif de surveillance selon la revendication 5, dans lequel une source électrique (S) produisant un courant à une fréquence allant de 2 à 5 megaherz est reliée au Q-mètre.

**Patentansprüche**

1. Verfahren zur Ueberwachung der Dicke einer metallischen Beschichtung auf einem Substrat (W), bei welchem eine Drosselspule (L) benachbart dem Substrat angeordnet und zwischen dieser und dem Substrat (W) eine relative Bewegung erzeugt wird, dadurch gekennzeichnet, dass die Drosselspule (L) zusammen mit einem Kondensator (C) einen Abstimmkreis erzeugt, welcher einen Q-Meter bildet, und dass eine Aenderung im Q des Meters während der relativen Bewegung gemessen wird.

2. Verfahren zur Ueberwachung der Dicke einer metallischen Beschichtung nach Anspruch 1, dadurch gekennzeichnet, dass der Q-Meter eine Anzahl Köpfe (H) aufweist, welche in Abständen zueinander quer zum Substrat (W) angeordnet sind.

3. Verfahren zur Ueberwachung der Dicke einer metallischen Beschichtung nach Anspruch 2, dadurch gekennzeichnet, dass die Ausgänge der Köpfe (H) multiplexiert sind.

4. Verfahren zur Ueberwachung der Dicke einer metallischen Beschichtung nach Anspruch 1, dadurch gekennzeichnet, dass der Q-Meter mit einem Strom mit einer Frequenz von 2 - 5 Megahertz gespeist wird.

5. Vorrichtung zur Ueberwachung der Dicke einer metallischen Beschichtung auf einem Substrat (W), mit Mitteln (9) zum Stützen des Substrats, mit einer Drosselspule (L), mit Mitteln zur Halterung der Drosselspule im Bereich des Substrats und mit Mitteln (9) zur Erzeugung einer relativen Bewegung zwischen dem Substrat und dar Drosselspule (L), dadurch gekennzeichnet, dass die Drosselspule (L) Teil eines Q-Meters bildet.

6. Vorrichtung zur Ueberwachung nach Anspruch 5, dadurch gekennzeichnet, dass der Q-Meter eine Anzahl Köpfe (H) umfasst, welche in Abständen zueinander quer zum Substrat (W) angeordnet sind.

7. Vorrichtung zur Ueberwachung nach Anspruch 6, dadurch gekennzeichnet, dass die Köpfe (H) mit einem Multiplexer (M) verbunden sind.

8. Vorrichtung zur Ueberwachung nach Anspruch 5, dadurch gekennzeichnet, dass eine Stromquelle (S) im Frequenzbereich von 2 - 5 Megahertz an den Q-Meter angeschlossen ist.

FIG.1

FIG.4

FIG.2

FIG.3

6